# EUROPÄISCHE PATENTSCHRIFT

(11) **EP 3 323 019 B1**
(45) Veröffentlichungstag und Bekanntmachung des Hinweises auf die Patenterteilung: **12.01.2022**
(21) Anmeldenummer: 16734227.8
(22) Anmeldetag: 22.06.2016
(51) Int. Cl.: G03F 7/20, G21K 1/06

(54) **VERFAHREN ZUM HERSTELLEN EINES SPIEGELS, INSBESONDERE FÜR EINE MIKROLITHOGRAPHISCHE PROJEKTIONSBELICHTUNGSANLAGE**
METHOD FOR PRODUCING A MIRROR, IN PARTICULAR FOR A MIRCOLITHOGRAPHIC PROJECTION EXPOSURE APPARATUS
PROCÉDÉ DE FABRICATION D'UN MIROIR, EN PARTICULIER POUR UN ÉQUIPEMENT D'EXPOSITION PAR PROJECTION POUR MICRO-LITHOGRAPHIE

(30) Priorität: 15.07.2015 DE 102015213249
(43) Veröffentlichungstag der Anmeldung: 23.05.2018
(73) Patentinhaber: Carl Zeiss SMT GmbH, 73447 Oberkochen (DE)
(72) Erfinder: DIER, Oliver, 73466 Lauchheim (DE); GRASSE, Christian, 85748 Garching (DE); WEBER, Jörn, 73430 Aalen (DE); SIX, Stephan, 86157 Augsburg (DE)
(74) Vertreter: Frank, Hartmut
(86) Internationale Anmeldenummer: PCT/EP2016/064385
(87) Internationale Veröffentlichungsnummer: WO 2017/009014

(56) Entgegenhaltungen:
- DE-A1-102011 005 543
- JP-A- 2010 199 503
- US-A1- 2007 081 229

## Beschreibung

### HINTERGRUND DER ERFINDUNG

### Gebiet der Erfindung

Die Erfindung betrifft ein Verfahren zum Herstellen eines Spiegels sowie einen Spiegel, insbesondere für eine mikrolithographische Projektionsbelichtungsanlage.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, z.B. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet.

Zur Spiegelherstellung werden beispielsweise Magnetron-Beschichtungsanlagen verwendet. Eine solche Magnetron-Beschichtungsanlage weist typischerweise eine Mehrzahl von Magnetrons auf, denen jeweils ein Target mit einem entsprechenden Beschichtungsmaterial zugeordnet ist. Zur Beschichtung eines Substrats wird dann das jeweilige Substrat (hierunter wird der Träger für die im Beschichtungsverfahren aufzubringende Schicht bzw. das aufzubringende Schichtsystem verstanden) über die den jeweiligen Targets bzw. Magnetrons zugewandten Beschichtungspositionen geführt.

Ein in der Praxis auftretendes Problem ist, dass zum einen im realen Beschichtungsprozess i.d.R. Schichtdickenfehler unvermeidbar sind und zum anderen auch ein Driften (d.h. eine zeitliche Änderung der im Beschichtungsprozess eingestellten Schichtdicken sowohl innerhalb eines Schichtaufbaus als auch über mehrere, nacheinander hergestellte Spiegel) stattfinden kann. Diese Probleme sind insbesondere bei EUV-Spiegeln mit periodisch aufgebauten Vielfachschichtsystemen (z.B. einem Reflexionsschichtstapel mit einer periodischen Abfolge von Absorber- und Spacerschichten oder einer Substratschutzschicht aus einer periodischen Abfolge von Absorber- und Spannungskompensationsschichten) besonders gravierend, weil sich die jeweiligen Schichtdickenfehler systematisch im Schichtdickenprofil fortpflanzen mit der Folge, dass bereits geringe Abweichungen der Einzelschichten von der jeweiligen Soll-Schichtdicke zu signifikanten Beeinträchtigungen der Gesamtperformance des optischen Systems führen.

Zum Stand der Technik wird lediglich beispielhaft auf WO 2014/206736 A1, WO 2011/032813 A1, WO 2008/133254 A1, EP 1 947 682 A1, WO 2007/043414 A1 sowie WO 97/33203 A1 verwiesen.

### ZUSAMMENFASSUNG DER ERFINDUNG

Vor dem obigen Hintergrund ist es eine Aufgabe der vorliegenden Erfindung, ein Verfahren zum Herstellen eines Spiegels sowie einen Spiegel, insbesondere für eine mikrolithographische Projektionsbelichtungsanlage, bereitzustellen, wobei eine durch die Spiegelherstellung bedingte Beeinträchtigung der Abbildungseigenschaften mit vergleichsweise geringem fertigungstechnischen Aufwand vermieden wird.

Diese Aufgabe wird durch die Merkmale der unabhängigen Patentansprüche gelöst.

Ein Verfahren zum Herstellen eines Spiegels, insbesondere für eine mikrolithographische Projektionsbelichtungsanlage, wobei in einer Beschichtungsanlage ein Spiegelsubstrat durch Aufbringen eines vorgegebenen Schichtaufbaus zur Erzielung eines vorgegebenen Soll-Schichtdickenprofils des Spiegels beschichtet wird, weist folgende Schritte auf:
- Virtuelles Unterteilen des vorgegebenen Schichtaufbaus in wenigstens zwei Schichtsysteme; und
- Beschichten des Spiegelsubstrats durch Aufbringen der wenigstens zwei Schichtsysteme unter Vorgabe unterschiedlicher Einzel-Soll-Schichtdickenprofile für diese Schichtsysteme, wobei diese Einzel-Soll-Schichtdickenprofile so gewählt werden, dass sich die jeweiligen Abweichungen der Einzel-Soll-Schichtdickenprofile von dem vorgegebenen Soll-Schichtdickenprofil in ihrem Beitrag zur Wellenfrontwirkung des Spiegels wenigstens teilweise kompensieren.

Der Erfindung liegt insbesondere das Konzept zugrunde, bei der Herstellung eines Spiegels mit einem vorgegebenen Soll-Schichtdickenprofil dieses Soll-Schichtdickenprofil nicht etwa für jede Einzelschicht bzw. für jedes einzelne der den Spiegel bildenden Schichtsysteme der Beschichtungsanlage vorzugeben, sondern stattdessen eine virtuelle Unterteilung des gesamten Schichtaufbaus des herzustellenden Spiegels in zwei oder mehrere Schichtsysteme vorzunehmen, wobei die für die betreffenden Schichtsysteme der Beschichtungsanlage jeweils vorgegebenen Einzel-Schichtdickenprofile von dem Soll-Schichtdickenprofil des gesamten Spiegels abweichen. Dabei werden konkret die einzelnen Soll-Schichtdickenprofile der den Spiegel unterteilenden Schichtsysteme so gewählt, dass sich die jeweiligen Abweichungen von dem Soll-Schichtdickenprofil in Summe möglichst gut kompensieren.

Dabei wird im Sinne der vorliegenden Anmeldung unter einem "Schichtdickenprofil" eine laterale Variation der Dicke einer Schicht bzw. eines Schichtsystems verstanden.

Gemäß einer Ausführungsform sind die Einzel-Soll-Schichtdickenprofile derart gewählt, dass über wenigstens 30% der optischen Wirkfläche die maximale Abweichung von dem vorgegebenen Soll-Schichtdickenprofil um wenigstens 50% im Vergleich zu einem analog aufgebauten Spiegel, bei welchem die Schichtsysteme ein identisches Schichtdickenprofil aufweisen, reduziert wird.

Gemäß einer Ausführungsform sind die Einzel-Soll-Schichtdickenprofile derart gewählt, dass über wenigstens 50%, weiter insbesondere wenigstens 80% der optischen Wirkfläche die maximale Abweichung von dem vorgegebenen Soll-Schichtdickenprofil um wenigstens 50%, insbesondere wenigstens 80%, im Vergleich zu einem analog aufgebauten Spiegel, bei welchem das erste und das zweite Schichtsystem ein identisches Schichtdickenprofil aufweisen, reduziert wird.

Gemäß einer Ausführungsform erfolgt die virtuelle Unterteilung des vorgegebenen Schichtaufbaus in genau zwei Schichtsysteme.

Gemäß einer Ausführungsform sind die Einzel-Soll-Schichtdickenprofile für diese Schichtsysteme hinsichtlich der optischen Weglänge zueinander komplementär. Dabei sollen von dem Begriff "komplementär" auch Ausführungen umfasst sein, bei dem sich die Einzel-Soll-Schichtdickenprofile zu einem nicht notwendigerweise konstanten Soll-Schichtdickenprofil ergänzen.

Gemäß einer Ausführungsform sind die wenigstens zwei Schichtsysteme rotationssymmetrisch.

Gemäß einer Ausführungsform weisen die wenigstens zwei Schichtsysteme jeweils eine Dickenvariation in lateraler Richtung auf.

Gemäß einer Ausführungsform entspricht für eine vorgegebene Arbeitswellenlänge das Soll-Schichtdickenprofil einem Soll-Reflektivitätsverlauf des Spiegels, wobei die Einzel-Soll-Schichtdickenprofile so gewählt werden, dass eine maximale Abweichung des tatsächlichen Reflektivitätsverlaufs von diesem Soll-Reflektivitätsverlauf für die Arbeitswellenlänge weniger als 0.5 %, insbesondere weniger als 0.3%, beträgt. Die Erfindung beinhaltet also weiter das Konzept, durch die Wahl der Einzel-Soll-Schichtdickenprofile möglichst keinen Einfluss auf den Reflektivitätsverlauf des Spiegels auszuüben.

Gemäß einer Ausführungsform weist der Spiegel ein Reflexionsschichtsystem auf, wobei das erste Schichtsystem eine nicht zum Reflexionsschichtsystem gehörende Funktionsschicht, insbesondere eine Substratschutzschicht, eine Spannungskompensationsschicht, eine Haftvermittlerschicht oder eine Polierschicht, ist, und wobei das zweite Schichtsystem ein Reflexionsschichtsystem ist.

Gemäß einer Ausführungsform umfassen das erste Schichtsystem und das zweite Schichtsystem jeweils wenigstens eine Schicht innerhalb eines Reflexionsschichtsystems. Dabei kann es sich bei diesem Reflexionsschichtsystem um ein Vielfachschichtsystem (z.B. eines für den Betrieb unter senkrechtem Einfall ausgelegten Spiegels) oder auch um eine Einzelschicht (z.B. eines für den Betrieb unter streifendem Einfall ausgelegten Spiegels) handeln. Im letzteren Falle stellen somit das erste Schichtsystem und das zweite Schichtsystem lediglich Teile einer Einzelschicht dar, welche durch virtuelles Unterteilen dieser Einzelschicht erhalten werden (wobei dann erfindungsgemäß unterschiedliche Einzel-Soll-Schichtdickenprofile für diese Teile vorgegeben werden). Gemäß einer Ausführungsform wird eines der wenigstens zwei Einzel-Soll-Schichtdickenprofile in Abhängigkeit von einem durch Messung an einem zuvor hergestellten Testspiegel ermittelten Schichtdickenprofil gewählt.

Die Erfindung betrifft weiter einen Spiegel, insbesondere für eine mikrolithographische Projektionsbelichtungsanlage, mit einem Spiegelsubstrat
- wobei auf dem Spiegelsubstrat ein erstes Schichtsystem mit einem ersten Schichtdickenprofil und wenigstens ein zweites Schichtsystem mit einem zweiten Schichtdickenprofil angeordnet sind, wobei eine Wellenfrontwirkung des zweiten Schichtsystems durch die Wellenfrontwirkung des ersten Schichtsystems wenigstens teilweise kompensiert wird;
- wobei die Einzel-Soll-Schichtdickenprofile so beschaffen sind, dass für eine vorgegebene Arbeitswellenlänge eine maximale Abweichung des Reflektivitätsverlaufs des Spiegels von einem gegebenen Soll-Reflektivitätsverlauf weniger als 0.5 % beträgt.

Gemäß einer Ausführungsform sind das erste und das zweite Schichtdickenprofil hinsichtlich der optischen Weglänge zueinander komplementär.

Gemäß einer Ausführungsform sind das erste Schichtdickenprofil und/oder das zweite Schichtdickenprofil rotationssymmetrisch.

Die Erfindung betrifft weiter eine mikrolithographische Projektionsbelichtungsanlage mit einer Beleuchtungseinrichtung und einem Projektionsobjektiv, wobei die Beleuchtungseinrichtung im Betrieb der Projektionsbelichtungsanlage eine in einer Objektebene des Projektionsobjektivs befindliche Maske beleuchtet und das Projektionsobjektiv Strukturen auf dieser Maske auf eine in einer Bildebene des Projektionsobjektivs befindliche lichtempfindliche Schicht abbildet, wobei die Projektionsbelichtungsanlage wenigstens einen Spiegel mit den vorstehend beschriebenen Merkmalen aufweist.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1-4: schematische Darstellungen zur Erläuterung des der Erfindung zugrundeliegenden Prinzips;
- Figur 5: eine schematische Darstellung zur Erläuterung eines bei der Herstellung eines Spiegels gemäß dem Stand der Technik auftretenden Problems;
- Figur 6-7: schematische Darstellungen zur Erläuterung des möglichen Schichtaufbaus eines erfindungsgemäßen Spiegels in unterschiedlichen Ausführungsformen; und
- Figur 8: eine schematische Darstellung einer für den Betrieb im EUV ausgelegten Projektionsbelichtungsanlage.

### DETAILLIERTE BESCHREIBUNG BEVORZUGTER

### AUSFÜHRUNGSFORMEN

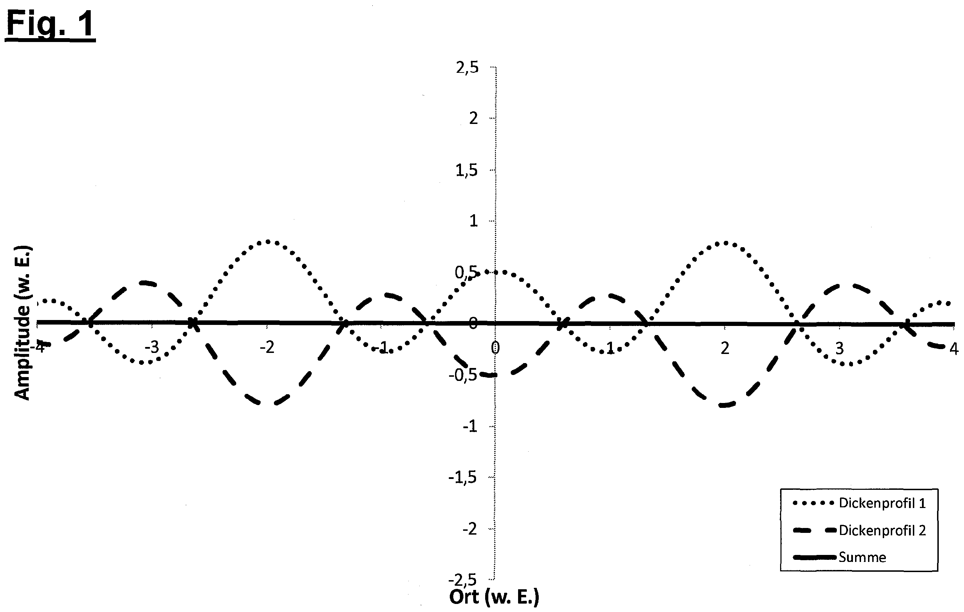

Im Weiteren wird das der vorliegenden Erfindung zugrundeliegende Prinzip unter Bezugnahme auf die schematischen Diagramme von Fig. 1-5 erläutert.

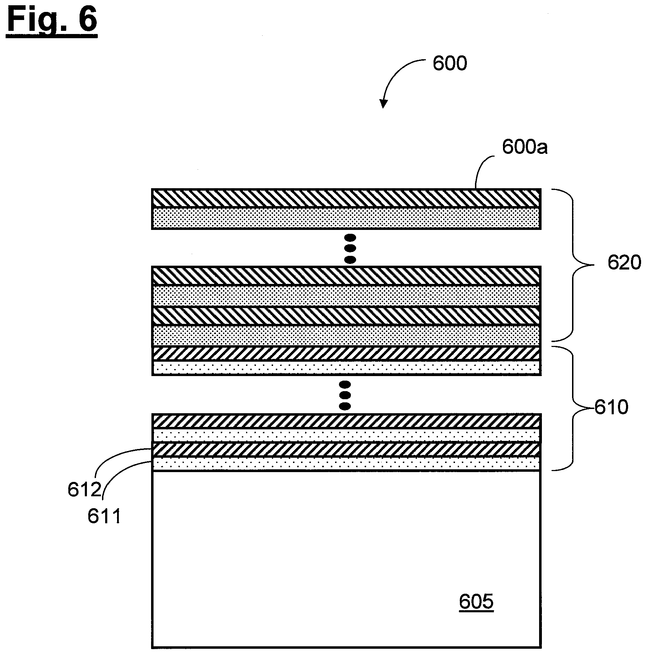

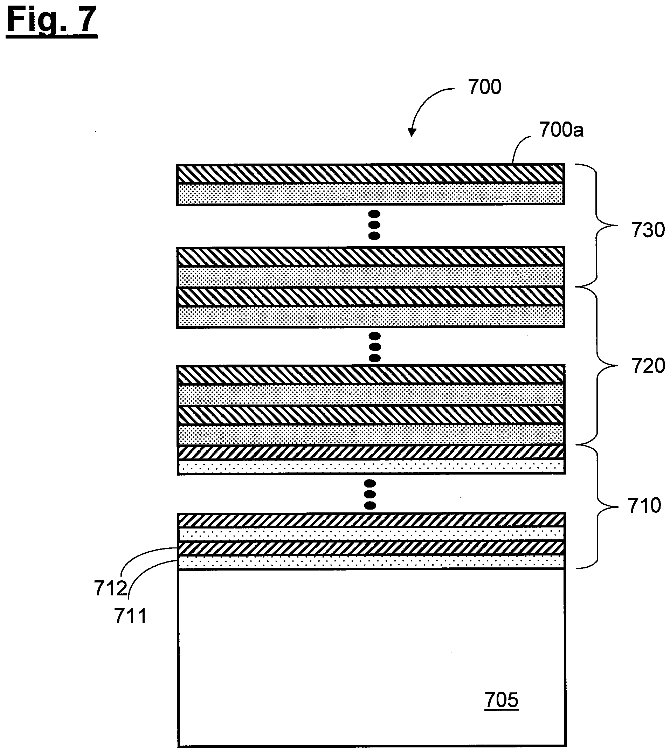

Hierbei wird zunächst davon ausgegangen, dass zur Herstellung eines EUV-Spiegels mit z.B. einer MagnetronBeschichtungsanlage oder einer Elektronenstrahl-Beschichtungsanlage ein gewünschtes Soll-Schichtdickenprofil für den gesamten Spiegel (einschließlich Spiegelsubstrat, Reflexionsschichtsystem sowie etwaigen Funktionsschichten) vorgegeben wird. Beispielhafte konkrete Schichtaufbauten eines erfindungsgemäßen Spiegels in unterschiedlichen Ausführungsformen werden unter Bezugnahme auf Fig. 6 und Fig. 7 noch detaillierter beschrieben.

Bei dem Soll-Schichtdickenprofil kann es sich sowohl um ein konstantes oder auch ein über die optische Wirkfläche des Spiegels variierendes Schichtdickenprofil handeln. In Fig. 1-5 ist jeweils die Amplitude der Abweichung von der Soll-Schichtdicke aufgetragen.

Erfindungsgemäß wird nun dieses Soll-Schichtdickenprofil nicht etwa für jede Einzelschicht bzw. für die einzelnen, den Spiegel bildenden Schichtsysteme der Beschichtungsanlage vorgegeben, sondern es erfolgt eine virtuelle Unterteilung in zwei oder mehrere Schichtsysteme, wobei die für die betreffenden Schichtsysteme der Beschichtungsanlage jeweils vorgegebenen Schichtdickenprofile von dem Soll-Schichtdickenprofil des gesamten Spiegels abweichen. Hierbei werden konkret die einzelnen Soll-Schichtdickenprofile der den Spiegel unterteilenden Schichtsysteme so gewählt, dass sich die jeweiligen Abweichungen von dem Soll-Schichtdickenprofil in Summe möglichst gut kompensieren.

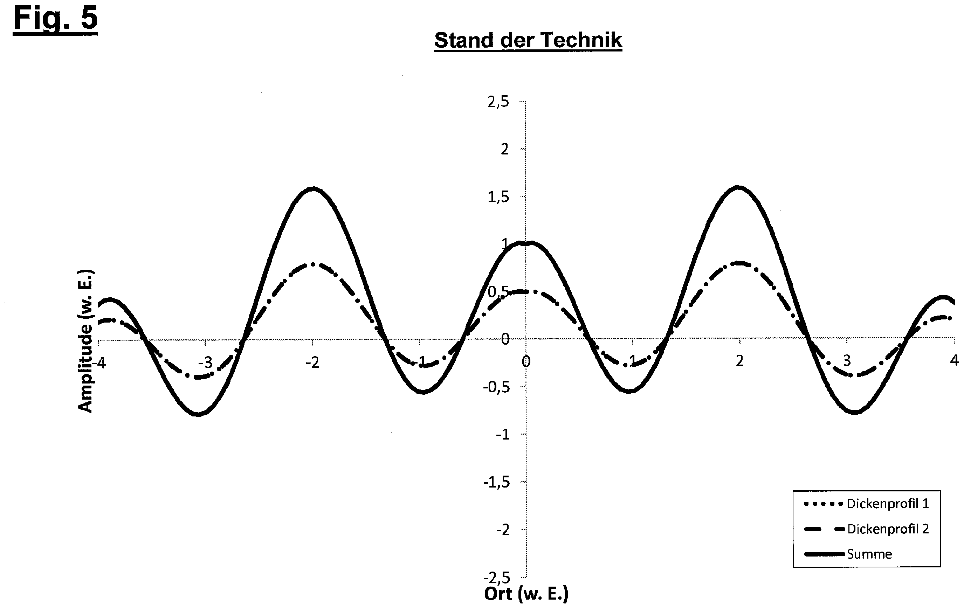

Zur Veranschaulichung des erfindungsgemäßen Konzepts zeigt zunächst Fig. 5 das Ergebnis der Addition von zwei einzelnen Schichtdickenprofilen, wobei es sich lediglich beispielhaft (und wie im Weiteren anhand von Fig. 6 noch detaillierter beschrieben) bei dem ersten Schichtsystem um eine Substratschutzschicht und bei dem zweiten Schichtsystem um ein Reflexionsschichtsystem eines EUV-Spiegels handeln kann.

Beide (mit gepunkteter bzw. gestrichelter Linie dargestellten) Schichtdickenprofile weisen gemäß Fig. 5 über die optische Wirkfläche des Spiegels gleichsinnige Amplitudenschwankungen im Dickenprofil auf, so dass das resultierende (mit durchgezogener Linie dargestellte) Dickenprofil infolge konstruktiver Überlagerung eine entsprechend größere (nämlich der Addition der Einzelamplituden entsprechende) Gesamtamplitude aufweist.

Erfindungsgemäß wird nun in einem ersten Ausführungsbeispiel - wie in Fig. 1 veranschaulicht - anstelle des in Fig. 5 gezeigten Verlaufs für das im obigen Beispiel erste Schichtsystem ein erstes Schichtdickenprofil (durch die gepunktete Linie in Fig. 1 dargestellt) und für das zweite Schichtsystem ein zweites Schichtdickenprofil (in Fig. 1 durch die gestrichelte Linie dargestellt) der Beschichtungsanlage derart vorgegeben, dass beide Schichtdickenprofile über die optische Wirkfläche des Spiegels zueinander komplementär verlaufen.

Mit anderen Worten weist die Amplitudenschwankung im ersten Schichtdickenprofil gerade dort "Berge" auf, wo die "Täler" des zweiten Schichtdickenprofils liegen, und umgekehrt. Im Ergebnis - d.h. nach Addition beider Schichtdickenprofile - wird für die (durch die durchgezogene Linie dargestellte) Gesamtamplitude die Abweichung von dem Soll-Schichtdickenprofil auf Null reduziert.

Ein Verfahren zur Herstellung des vorstehend anhand von Fig. 1 beschriebenen Spiegels kann in der Praxis z.B. folgenden Ablauf haben:
Zunächst kann für einen mit einer Beschichtungsanlage wie z.B. einer Magnetron-Beschichtungsanlage bereits hergestellten Spiegel der Schichtdickenverlauf interferometrisch ermittelt werden. Sodann kann für einen oder mehrere weitere, mit der Beschichtungsanlage herzustellende(n) Spiegel mit demselben gewünschten Spiegeldesign eine mathematisch gedachte Trennlinie innerhalb des Schichtdesigns definiert werden, wobei durch diese Trennlinie der Schichtaufbau des jeweiligen Spiegels virtuell in ein erstes Schichtsystem und ein zweites Schichtsystem unterteilt wird. Dann wird z.B. für das erste Schichtsystem der durch die virtuelle Aufteilung erhaltenen Schichtsysteme das der Beschichtungsanlage vorgegebene Schichtdickenprofil unverändert gelassen, wohingegen für das zweite Schichtsystem der durch die Aufteilung erhaltenen Schichtsysteme das hierzu inverse Schichtdickenprofil aufgeprägt (bzw. das inverse Soll-Schichtdickenprofil der Beschichtungsanlage vorgegeben) wird.

Insbesondere kann zunächst für einen bereits mit der Beschichtungsanlage hergestellten Spiegel die Abweichung von dem Soll-Dickenprofil über die gesamte optische Wirkfläche des Spiegels (d.h. die Abweichung von einem gewünschten Soll-Verlauf bzw. Soll-Design) gemessen werden. Sodann erfolgt eine virtuelle Unterteilung des gesamten Schichtaufbaus des Spiegels in zumindest zwei Schichtsysteme (wobei die Lage der virtuellen Trennlinie, entlang der diese Aufteilung erfolgt, grundsätzlich beliebig ist). Dann wird für ein erstes der beiden durch diese virtuelle Aufteilung erhaltenen Schichtsysteme bewusst ein "Fehler" bzw. eine Abweichung im Schichtdickenprofil eingestellt, und zwar in solcher Weise, dass das Schichtdickenprofil gerade der gemessenen Abweichung vom gewünschten Soll-Verlauf im Schichtdickenprofil mit entgegengesetztem Vorzeichen entspricht (wozu beispielsweise die Geschwindigkeit oder Leistung während des Beschichtungsprozesses in z.B. einer Magnetron-Beschichtungsanlage entsprechend eingestellt wird). Das andere, durch die virtuelle Aufteilung entstandene Schichtsystem wird unverändert gelassen. Hierdurch wird letztlich die erfindungsgemäße Kompensation insofern erzielt, als idealerweise die Abweichung des gesamten Spiegels vom Soll-Schichtdickenprofil eliminiert wird.

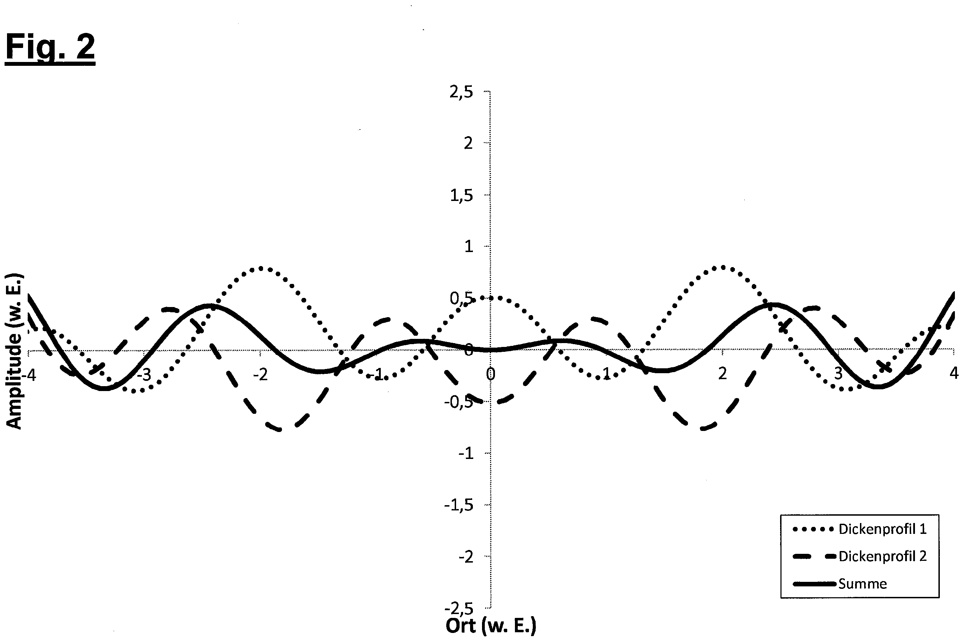

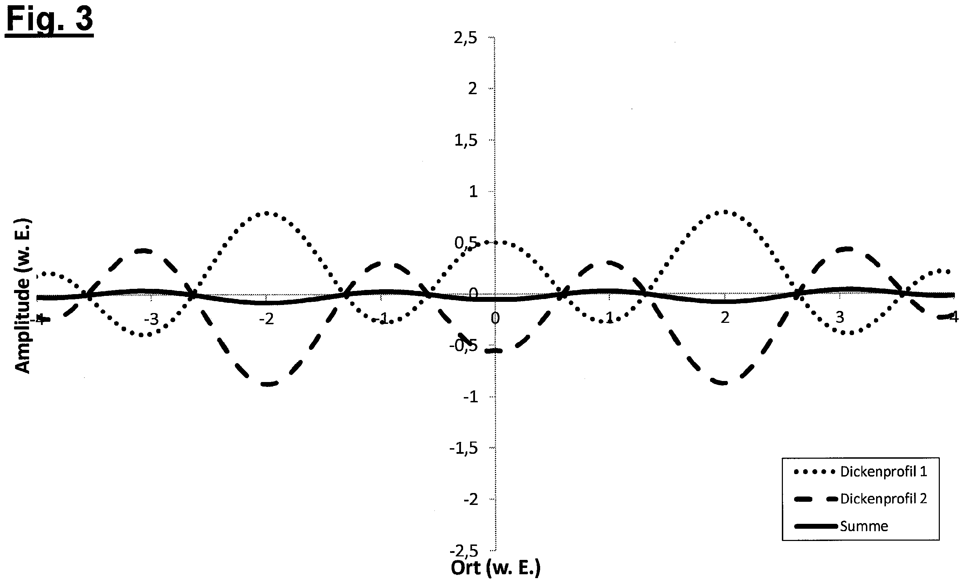

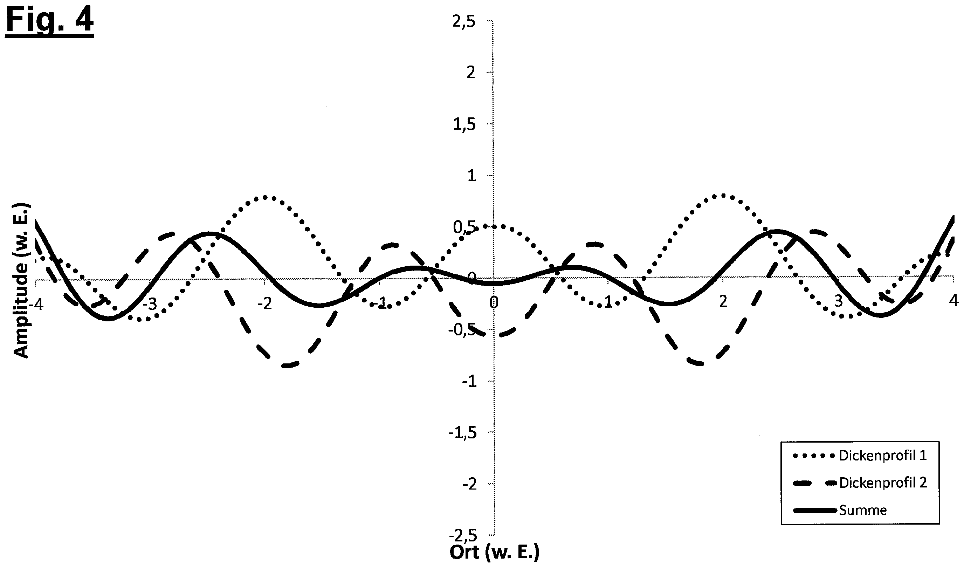

In Fig. 2, 3 und 4 werden im Weiteren die Auswirkungen unvermeidlicher Fehler des Beschichtungsprozesses beschrieben. Mit anderen Worten zeigen die Diagramme von Fig. 2-4 jeweils nach Vorgabe der Schichtdickenprofile von Fig. 1 tatsächlich erhaltene Schichtdickenprofile, wobei in Fig. 2 von einem Ortsfehler von 10%, in Fig. 3 einem Amplitudenfehler von 10% und in Fig. 4 sowohl von einem Amplituden- als auch einem Ortsfehler von jeweils 10% ausgegangen wurde. Es zeigt sich jeweils, dass für das in Summe erhaltene Schichtdickenprofil nunmehr über die optische Wirkfläche des Spiegels zwar endliche Abweichungen von dem jeweiligen Soll-Schichtdickenprofil erhalten werden, diese jedoch wesentlich kleiner sind als in dem zuvor anhand von Fig. 5 beschriebenen Fall (mit konstruktiver Überlagerung der einzelnen Schichtdickenprofile). Weiter zeigt sich, dass sich Abweichungen vom gewünschten Schichtdicken- bzw. Wellenfrontverlauf von zunächst einem vergleichsweise niederfrequenten Verlauf (gemäß Fig. 5) zu einem vergleichsweise hochfrequenten Verlauf verlagern.

Im Ergebnis wird durch die vorstehend beschriebene, erfindungsgemäße Vorgabe von Einzel-Schichtdickenprofilen für die einzelnen Schichtsysteme (in welche der Spiegel "unterteilt" wird) erreicht, dass unvermeidliche Fehler während des Beschichtungsprozesses weniger stark zum Tragen kommen, als es der Fall wäre, wenn das letztendlich gewünschte Soll-Schichtdickenprofil jeder Einzelschicht bzw. jedem einzelnen Schichtsystem des Spiegels vorgegeben würde.

Die erfindungsgemäße Einstellung der jeweils vorgegebenen Schichtdickenprofile kann im Falle einer Magnetron-Beschichtungsanlage in dem Fachmann grundsätzlich bekannter Weise über eine Änderung der Geschwindigkeit, eine Änderung der Leistung oder durch eine Verwendung geeigneter Blenden erfolgen. In einer Elektronenstrahl-Beschichtungsanlage kann entsprechend die Einstellung der erfindungsgemäß vorgegebenen Schichtdickenprofile über eine Verwendung geeigneter Blenden erfolgen.

Vorzugsweise sind hierbei die einzelnen Schichtdickenprofile derart gewählt, dass die maximale Abweichung von einem analog aufgebauten Spiegel (Referenzspiegel), in welchem die beiden Schichtsysteme ein identisches (sowie gleichsinnig verlaufendes) Schichtdickenprofil aufweisen, um wenigstens 50%, insbesondere um wenigstens 80% reduziert wird. Der hierbei zum Vergleich herangezogene Spiegel ist vorzugsweise ein Spiegel, bei welchem sich die entsprechenden Schichtdickenprofile der Schichtsysteme, da sie gleichsinnig (und nicht komplementär) zueinander verlaufen, konstruktiv überlagern. Mit anderen Worten sind bei dem zum Vergleich herangezogenen Spiegel die beiden Schichtdickenprofile gleich, so dass es zu einer maximalen Überlagerung der jeweiligen Abweichungen von der Soll-Schichtdicke kommt.

Der durch die Erfindung erzielte Vorteil kommt besonders zum Tragen bei EUV-Spiegeln mit periodisch aufgebauten Vielfachschichtsystemen (z.B. einem Reflexionsschichtstapel mit einer periodischen Abfolge von Absorber- und Spacerschichten oder einer Substratschutzschicht aus einer periodischen Abfolge von Absorber- und Spannungskompensationsschichten), da in einem solchen Aufbau sich die im Beschichtungsprozess unvermeidlichen Schichtdickenfehler systematisch im Schichtdickenprofil fortpflanzen mit der Folge, dass bereits geringe Abweichungen der Einzelschichten von der jeweiligen Soll-Schichtdicke zu signifikanten Beeinträchtigungen der Gesamtperformance des optischen Systems führen.

Im Weiteren werden beispielhafte Schichtaufbauten eines Spiegels unter Bezugnahme auf Fig. 6 und Fig. 7 beschrieben, in denen die Erfindung realisierbar ist.

Gemäß Fig. 6 weist ein Spiegel 600 in grundsätzlich für sich bekannter Weise auf einem Substrat 605 ein Reflexionsschichtsystem auf, welcher in der dargestellten Ausführungsform eine alternierende Abfolge aus sogenannten SpacerSchichten aus einem Material mit vergleichsweise geringer Absorption und größerem Brechungsindex bei der Arbeitswellenlänge und sogenannten Absorber-Schichten aus einem Material mit vergleichsweise größerer Absorption und kleinerem Brechungsindex bei der Arbeitswellenlänge (sowie ggf. Diffusionssperrschichten etc.) aufweist. Ohne dass die Erfindung auf konkrete Ausgestaltungen dieses Reflexionsschichtsystems beschränkt wäre, kann ein lediglich beispielhafter geeigneter Aufbau etwa 50 Lagen bzw. Schichtpakete eines Schichtsystems aus Molybdän (Mo)-Schichten (als Absorber-Schichten) mit einer Schichtdicke von jeweils 2.8nm und Silizium (Si)-Schichten (als Spacer-Schichten) mit einer Schichtdicke von jeweils 4.2nm umfassen.

Des Weiteren weist der Spiegel 600 gemäß Fig. 6 zum Schutz des Spiegelsubstrats 605 vor im Betrieb des Spiegels 600 auf die optische Wirkfläche 600a auftreffender und die Reflexionsschicht 620 durchdringender elektromagnetischer Strahlung zwischen dem Reflexionsschichtsystem 620 und dem Spiegelsubstrat 605 eine Substratschutzschicht auf.

Die Substratschutzschicht weist im Ausführungsbeispiel von Fig. 6 ihrerseits eine alternierende Aufeinanderfolge von Absorberschichten 612 aus einem ersten Material (mit entsprechend hohem Absorptionsanteil im Brechungsindex, z.B. Silber (Ag), Platin (Pt), Zinn (Sn), Zink (Zn), Kupfer (Cu), Wolfram (W), Nickel (Ni) oder Kobalt (Co)) und Schichtspannungskompensationsschichten 611 aus einem zweiten Material (z.B. Molybdän (Mo) oder Ruthenium (Ru)) auf. Während die Schichtspannungskompensationsschichten 611 dazu dienen, eine gegebenenfalls im gesamten Schichtaufbau des Spiegels 600 vorhandene, unerwünschte mechanische Schichtspannung zu kompensieren, sorgen die Absorberschichten 612 aufgrund ihrer geringen Transmission für EUV-Strahlung (insbesondere von weniger als 0.1%) dafür, dass elektromagnetische Strahlung etwa in Form von Streulicht vom Spiegelsubstrat 605 ferngehalten wird, wo diese elektromagnetische Strahlung eine Kompaktierung oder anderweitige Schädigung des Spiegelsubstratmaterials hervorrufen könnte.

Im Beispiel von Fig. 6 bildet die Substratschutzschicht auf dem Spiegelsubstrat 605 ein erstes Schichtsystem 610 mit einem ersten Schichtdickenprofil, und das Reflexionsschichtsystem bildet ein zweites Schichtsystem 620 mit einem zweiten Schichtdickenprofil. Dabei sind die Schichtdickenprofile des ersten und des zweiten Schichtsystems so gewählt, dass Wellenfrontwirkung des zweiten Schichtsystems 620 durch die Wellenfrontwirkung des ersten Schichtsystems 610 wenigstens teilweise kompensiert wird.

Die Erfindung ist nicht auf Schichtsysteme mit mehreren Schichten wie in Fig. 6 gezeigt beschränkt. So kann in weiteren Ausführungsformen auch das erfindungsgemäße Kompensationsprinzip auf zwei Einzelschichten angewandt werden, welche sich im Schichtdickenprofil in der vorstehend beschriebenen Weise hinsichtlich der Abweichung von der jeweiligen Soll-Schichtdicke gegenseitig kompensieren. Bei diesen Einzelschichten kann es sich beispielsweise auch um die Reflexionsschicht eines für den Betrieb unter streifendem Einfall ausgelegten Spiegels (GI-Spiegel, GI = "**g**razing **i**ncidence" = streifender Einfall) handeln, welche wiederum lediglich beispielhaft als Ruthenium-Schicht mit einer Dicke von 50 nm ausgestaltet sein kann. Ebenso kann es sich bei dem "zweiten Schichtsystem" auch um eine Einzelschicht handeln, z.B. eine als Absorberschicht ausgestaltete Substratschutzschicht des betreffenden GI-Spiegels. Ferner kann es sich bei den beiden Einzelschichten bzw. Schichtsystemen auch um durch virtuelles Unterteilen einer Einzelschicht (z.B. einer Reflexionsschicht eines GI-Spiegels, welche beispielhaft als Ruthenium-Schicht mit einer Dicke von 50 nm ausgestaltet sein kann) erhaltene Schichten handeln, für welche dann erfindungsgemäß unterschiedliche Einzel-Soll-Schichtdickenprofile analog zu den beschriebenen Ausführungsformen vorgegeben werden.

Die erfindungsgemäße "Aufteilung" des Spiegels hinsichtlich der für die Beschichtungsanlage separat vorgegebenen Schichtdickenprofile ist nicht auf die Unterteilung in zwei Schichtsysteme beschränkt. In weiteren Ausführungsformen kann auch eine Unterteilung in mehr als zwei Schichtsysteme erfolgen.

Ein entsprechendes Ausführungsbeispiel ist in Fig. 7 lediglich schematisch dargestellt.

Dabei kann lediglich beispielhaft eines dieser Schichtsysteme wiederum analog zu Fig. 6 als erstes Schichtsystem 710 eine (als periodische Vielfachschicht aufgebaute) Substratschutzschicht mit z.B. 40 Teilschichtpaketen aus jeweils einer Absorberschicht 712 und einer Spannungskompensationsschicht 711 umfassen. Hingegen ist gemäß Fig. 7 das Reflexionsschichtsystem in zwei Gruppen bzw. Schichtsysteme 720, 730 (also ein zweites und ein drittes Schichtsystem) unterteilt. Dabei umfasst das zweite Schichtsystem 720 eine erste Gruppe innerhalb des Reflexionsschichtsystems aus z.B. 50 Teilschichtpaketen aus jeweils einer Absorber- und einer Spacerschicht, und das dritte Schichtsystem 730 umfasst eine zweite Gruppe innerhalb des Reflexionsschichtsystems aus 20 weiteren Teilschichtpaketen aus jeweils einer Absorber- und einer Spacerschicht.

Vorzugsweise sollte hierbei jedoch der Reflexionsschichtstapel wenigstens 50 Perioden mit jeweils gleich verlaufendem Schichtdickenprofil umfassen, damit insgesamt eine hinreichende Reflektivität erzielt wird. In dem o.g. Ausführungsbeispiel werden nun zusätzlich zu diesen 50 Perioden weitere 20 Perioden des Reflexionsschichtsystems als drittes Schichtsystem 730 hinzugefügt, welche jeweils im Schichtdickenprofil gerade so beschaffen sind, dass die in den übrigen Schichtsystemen des EUV-Spiegels (d.h. dem vorstehend genannten zweiten Schichtsystem 720 aus 50 Perioden innerhalb des Reflexionsschichtstapels und dem ersten Schichtsystem 710 in Form der Substratschutzschicht) vorhandenen Abweichungen vom Soll-Schichtdickenprofil gerade kompensiert werden.

Das vorstehend anhand von Fig. 7 beschriebene Ausführungsbeispiel kann dahingehend verallgemeinert werden, dass der gesamte, auf dem Spiegelsubstrat vorhandene Schichtaufbau in eine beliebige Anzahl (d.h. insbesondere auch in mehr als drei) Schichtsysteme in dem Sinne "unterteilt" sein kann, dass in Summe die in jedem Schichtsystem vorhandenen Abweichungen vom Soll-Schichtdickenprofil kompensiert werden.

Vorzugsweise ist in dem vorstehenden Ausführungsbeispiel die Summe der überlagerten Schichtdickenprofile sämtlicher Schichtsysteme 710, 720 und 730 vorzugsweise über wenigstens 80% der optischen Wirkfläche kleiner als 80% der Maximalamplitude bzw. der maximalen Abweichung von der Soll-Schichtdicke eines analog aufgebauten (Vergleichs- bzw. Referenz-)Spiegels mit jeweils gleich verlaufenden Schichtdickenprofilen.

In absoluter Hinsicht kann z.B. von einem maximalen Wellenfrontfehler des EUV-Systems in der Größenordnung von 0.5 bis 1 nm ausgegangen werden. Dementsprechend kann z.B. für einen einzelnen EUV-Spiegel ein maximaler Wellenfrontfehler von 300 pm gefordert werden. Vorzugsweise weist der erfindungsgemäße Spiegel eine maximale Abweichung von dem jeweils vorgegebenen Soll-Schichtdickenprofil kleiner als 1 nm, insbesondere kleiner als 500 pm, weiter insbesondere kleiner als 300 pm auf.

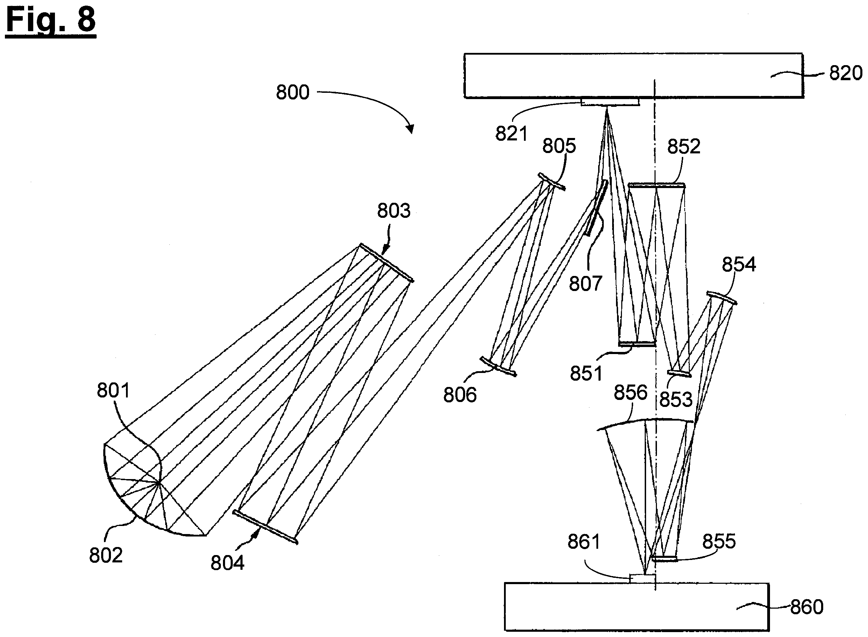

Fig. 8 zeigt eine schematische Darstellung einer beispielhaften für den Betrieb im EUV ausgelegten Projektionsbelichtungsanlage 800.

Gemäß Fig. 8 weist eine Beleuchtungseinrichtung der Projektionsbelichtungsanlage 800 einen Feldfacettenspiegel 803 und einen Pupillenfacettenspiegel 804 auf. Auf den Feldfacettenspiegel 803 wird das Licht einer Lichtquelleneinheit, welche eine Plasmalichtquelle 801 und einen Kollektorspiegel 802 umfasst, gelenkt. Im Lichtweg nach dem Pupillenfacettenspiegel 804 sind ein erster Teleskopspiegel 805 und ein zweiter Teleskopspiegel 806 angeordnet. Im Lichtweg nachfolgend ist ein unter streifendem Einfall betriebener Umlenkspiegel 807 angeordnet, der die auf ihn treffende Strahlung auf ein Objektfeld in der Objektebene eines in Fig. 8 lediglich angedeuteten Projektionsobjektivs lenkt. Am Ort des Objektfeldes ist eine reflektive strukturtragende Maske 821 auf einem Maskentisch 820 angeordnet, die mit Hilfe eines Projektionsobjektivs in eine Bildebene abgebildet wird, in welcher sich ein mit einer lichtempfindlichen Schicht (Photoresist) beschichtetes Substrat 861 auf einem Wafertisch 860 befindet.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

## Patentansprüche

1. Verfahren zum Herstellen eines Spiegels, insbesondere für eine mikrolithographische Projektionsbelichtungsanlage, wobei in einer Beschichtungsanlage ein Spiegelsubstrat durch Aufbringen eines vorgegebenen Schichtaufbaus zur Erzielung eines vorgegebenen Soll-Schichtdickenprofils des Spiegels beschichtet wird, **dadurch gekennzeichnet, dass** das Verfahren folgende Schritte aufweist:
a) Virtuelles Unterteilen des vorgegebenen Schichtaufbaus in wenigstens zwei Schichtsysteme (610, 710, 620, 720, 730); und
b) Beschichten des Spiegelsubstrats (605, 705) durch Aufbringen der wenigstens zwei Schichtsysteme (610, 710, 620, 720, 730) unter Vorgabe unterschiedlicher Einzel-Soll-Schichtdickenprofile für diese Schichtsysteme (610, 710, 620, 720, 730), wobei diese Einzel-Soll-Schichtdickenprofile so gewählt werden, dass sich die jeweiligen Abweichungen der Einzel-Soll-Schichtdickenprofile von dem vorgegebenen Soll-Schichtdickenprofil in ihrem Beitrag zur Wellenfrontwirkung des Spiegels wenigstens teilweise kompensieren.

2. Verfahren nach Anspruch 1, **dadurch gekennzeichnet, dass** die Einzel-Soll-Schichtdickenprofile derart gewählt werden, dass über wenigstens 30% der optischen Wirkfläche (600a, 700a) die maximale Abweichung von dem vorgegebenen Soll-Schichtdickenprofil um wenigstens 50% im Vergleich zu einem analog aufgebauten Spiegel, bei welchem die Schichtsysteme ein identisches Schichtdickenprofil aufweisen, reduziert wird.

3. Verfahren nach Anspruch 1 oder 2, **dadurch gekennzeichnet, dass** die Einzel-Soll-Schichtdickenprofile derart gewählt werden, dass über wenigstens 50%, weiter insbesondere wenigstens 80% der optischen Wirkfläche die maximale Abweichung von dem vorgegebenen Soll-Schichtdickenprofil um wenigstens 50%, insbesondere wenigstens 80%, im Vergleich zu einem analog aufgebauten Spiegel, bei welchem das erste und das zweite Schichtsystem ein identisches Schichtdickenprofil aufweisen, reduziert wird.

4. Verfahren nach einem der Ansprüche 1 bis 3, **dadurch gekennzeichnet, dass** die virtuelle Unterteilung des vorgegebenen Schichtaufbaus im Schritt a) in genau zwei Schichtsysteme erfolgt.

5. Verfahren nach Anspruch 4, **dadurch gekennzeichnet, dass** die Einzel-Soll-Schichtdickenprofile für diese Schichtsysteme (610, 710, 620, 720) hinsichtlich der optischen Weglänge zueinander komplementär sind.

6. Verfahren nach einem der vorhergehenden Ansprüche, **dadurch gekennzeichnet, dass** die wenigstens zwei Schichtsysteme (610, 710, 620, 720, 730) rotationssymmetrisch sind.

7. Verfahren nach einem der vorhergehenden Ansprüche, **dadurch gekennzeichnet, dass** die wenigstens zwei Schichtsysteme (610, 710, 620, 720, 730) jeweils eine Dickenvariation in lateraler Richtung aufweisen.

8. Verfahren nach einem der vorhergehenden Ansprüche, **dadurch gekennzeichnet, dass** für eine vorgegebene Arbeitswellenlänge das Soll-Schichtdickenprofil einem Soll-Reflektivitätsverlauf des Spiegels entspricht, wobei die Einzel-Soll-Schichtdickenprofile so gewählt werden, dass eine maximale Abweichung des tatsächlichen Reflektivitätsverlaufs von diesem Soll-Reflektivitätsverlauf für die Arbeitswellenlänge weniger als 0.5 %, insbesondere weniger als 0.3%, beträgt.

9. Verfahren nach einem der vorhergehenden Ansprüche, **dadurch gekennzeichnet, dass** der Spiegel ein Reflexionsschichtsystem aufweist, wobei das erste Schichtsystem (610, 710) eine nicht zum Reflexionsschichtsystem gehörende Funktionsschicht, insbesondere eine Substratschutzschicht, eine Spannungskompensationsschicht, eine Haftvermittlerschicht oder eine Polierschicht, ist, und wobei das zweite Schichtsystem (620, 720) ein Reflexionsschichtsystem ist.

10. Verfahren nach einem der Ansprüche 1 bis 8, **dadurch gekennzeichnet, dass** das erste Schichtsystem und das zweite Schichtsystem jeweils wenigstens eine Schicht innerhalb eines Reflexionsschichtsystems umfassen.

11. Verfahren nach einem der vorhergehenden Ansprüche, **dadurch gekennzeichnet, dass** eines der wenigstens zwei Einzel-Soll-Schichtdickenprofile in Abhängigkeit von einem durch Messung an einem zuvor hergestellten Testspiegel ermittelten Schichtdickenprofil gewählt wird.

12. Spiegel, insbesondere für eine mikrolithographische Projektionsbelichtungsanlage, mit einem Spiegelsubstrat
• wobei auf dem Spiegelsubstrat (605, 705) ein erstes Schichtsystem (610, 710) mit einem ersten Schichtdickenprofil und wenigstens ein zweites Schichtsystem (620, 720) mit einem zweiten Schichtdickenprofil angeordnet sind, wobei eine Wellenfrontwirkung des zweiten Schichtsystems (620, 720) durch die Wellenfrontwirkung des ersten Schichtsystems (610, 710) wenigstens teilweise kompensiert wird, **dadurch gekennzeichnet, dass**
• die Einzel-Soll-Schichtdickenprofile so beschaffen sind, dass für eine vorgegebene Arbeitswellenlänge eine maximale Abweichung des Reflektivitätsverlaufs des Spiegels von einem gegebenen Soll-Reflektivitätsverlauf weniger als 0.5 % beträgt.

13. Spiegel nach Anspruch 12, **dadurch gekennzeichnet, dass** das erste und das zweite Schichtdickenprofil hinsichtlich der optischen Weglänge zueinander komplementär sind.

14. Spiegel nach Anspruch 12 oder 13, **dadurch gekennzeichnet, dass** das erste Schichtdickenprofil und/oder das zweite Schichtdickenprofil rotationssymmetrisch sind.

15. Mikrolithographische Projektionsbelichtungsanlage mit einer Beleuchtungseinrichtung und einem Projektionsobjektiv, wobei die Beleuchtungseinrichtung im Betrieb der Projektionsbelichtungsanlage eine in einer Objektebene des Projektionsobjektivs befindliche Maske beleuchtet und das Projektionsobjektiv Strukturen auf dieser Maske auf eine in einer Bildebene des Projektionsobjektivs befindliche lichtempfindliche Schicht abbildet, wobei die Projektionsbelichtungsanlage wenigstens einen Spiegel nach einem der Ansprüche 12 bis 14 aufweist.

## Claims

1. Method for producing a mirror, in particular for a microlithographic projection exposure apparatus, wherein in a coating apparatus a mirror substrate is coated by a process of applying a predefined layer construction for achieving a predefined target layer thickness profile of the mirror, **characterized in that** the method comprises the following steps:
a) virtually subdividing the predefined layer construction into at least two layer systems (610, 710, 620, 720, 730); and
b) coating the mirror substrate (605, 705) by applying the at least two layer systems (610, 710, 620, 720, 730) in conjunction with predefining different individual target layer thickness profiles for said layer systems (610, 710, 620, 720, 730), wherein said individual target layer thickness profiles are chosen such that the respective deviations of the individual target layer thickness profiles from the predefined target layer thickness profile at least partly compensate for one another in terms of the contribution thereof to the wavefront effect of the mirror.

2. Method according to Claim 1, **characterized in that** the individual target layer thickness profiles are chosen in such a way that over at least 30% of the optical effective surface (600a, 700a) the maximum deviation from the predefined target layer thickness profile is reduced by at least 50% in comparison with an analogously constructed mirror in which the layer systems have an identical layer thickness profile.

3. Method according to Claim 1 or 2, **characterized in that** the individual target layer thickness profiles are chosen in such a way that over at least 50%, more particularly at least 80%, of the optical effective surface, the maximum deviation from the predefined target layer thickness profile is reduced by at least 50%, in particular at least 80%, in comparison with an analogously constructed mirror in which the first and second layer systems have an identical layer thickness profile.

4. Method according to any of Claims 1 to 3, **characterized in that** the predefined layer construction is virtually subdivided into exactly two layer systems in step a).

5. Method according to Claim 4, **characterized in that** the individual target layer thickness profiles for said layer systems (610, 710, 620, 720) are complementary to one another with regard to the optical path length.

6. Method according to any of the preceding claims, **characterized in that** the at least two layer systems (610, 710, 620, 720, 730) are rotationally symmetrical.

7. Method according to any of the preceding claims, **characterized in that** the at least two layer systems (610, 710, 620, 720, 730) each have a thickness variation in a lateral direction.

8. Method according to any of the preceding claims, **characterized in that** for a predefined operating wavelength the target layer thickness profile corresponds to a target reflectivity profile of the mirror, wherein the individual target layer thickness profiles are chosen such that a maximum deviation of the actual reflectivity profile from said target reflectivity profile for the operating wavelength is less than 0.5%, in particular less than 0.3%.

9. Method according to any of the preceding claims, **characterized in that** the mirror has a reflection layer system, wherein the first layer system (610, 710) is a functional layer that does not belong to the reflection layer system, in particular a substrate protection layer, a stress compensation layer, an adhesion promoter layer or a polishing layer, and wherein the second layer system (620, 720) is a reflection layer system.

10. Method according to any of Claims 1 to 8, **characterized in that** the first layer system and the second layer system each comprise at least one layer within a reflection layer system.

11. Method according to any of the preceding claims, **characterized in that** one of the at least two individual target layer thickness profiles is chosen depending on a layer thickness profile determined by measurement on a previously produced test mirror.

12. Mirror, in particular for a microlithographic projection exposure apparatus, comprising a mirror substrate
• wherein a first layer system (610, 710) having a first layer thickness profile and at least one second layer system (620, 720) having a second layer thickness profile are arranged on the mirror substrate (605, 705) wherein a wavefront effect of the second layer system (620, 720) is at least partly compensated for by the wavefront effect of the first layer system (610, 710), **characterized in that**
• the individual target layer thickness profiles are constituted such that for a predefined operating wavelength a maximum deviation of the reflectivity profile of the mirror from a given target reflectivity profile is less than 0.5%.

13. Mirror according to Claim 12, **characterized in that** the first and second layer thickness profiles are complementary to one another with regard to the optical path length.

14. Mirror according to Claim 12 or 13, **characterized in that** the first layer thickness profile and/or the second layer thickness profile are/is rotationally symmetrical.

15. Microlithographic projection exposure apparatus comprising an illumination device and a projection lens, wherein during operation of the projection exposure apparatus the illumination device illuminates a mask situated in an object plane of the projection lens and the projection lens images structures on said mask onto a light-sensitive layer situated in an image plane of the projection lens, wherein the projection exposure apparatus comprises at least one mirror according to any of Claims 12 to 14.

## Revendications

1. Procédé de fabrication d'un miroir, en particulier pour un équipement d'exposition par projection pour microlithographie, dans lequel, dans un équipement de revêtement, un substrat de miroir est revêtu par l'application d'une structure en couches prédéfinie afin d'obtenir un profil d'épaisseur de couche théorique prédéfini du miroir,
**caractérisé en ce que** le procédé présente les étapes suivantes consistant à :
a) subdiviser virtuellement la structure en couches prédéfinie en au moins deux systèmes de couches (610, 710, 620, 720, 730) ; et
b) revêtir le substrat de miroir (605, 705) par l'application des au moins deux systèmes de couches (610, 710, 620, 720, 730) en prédéfinissant différents profils d'épaisseur de couche théoriques individuels pour ces systèmes de couches (610, 710, 620, 720, 730), ces profils d'épaisseur de couche théoriques individuels étant sélectionnés de telle sorte que les écarts respectifs des profils d'épaisseur de couche théoriques individuels par rapport au profil d'épaisseur de couche théorique prédéfini se compensent au moins partiellement dans leur contribution à l'effet de front d'onde du miroir.

2. Procédé selon la revendication 1, **caractérisé en ce que** les profils d'épaisseur de couche théoriques individuels sont sélectionnés de telle sorte que sur au moins 30 % de la surface optique active (600a, 700a) l'écart maximal par rapport au profil d'épaisseur de couche théorique prédéfini est réduit d'au moins 50 % en comparaison avec un miroir de structure analogique dans lequel les systèmes de couches présentent un profil d'épaisseur de couche identique.

3. Procédé selon la revendication 1 ou 2, **caractérisé en ce que** les profils d'épaisseur de couche théoriques individuels sont sélectionnés de telle sorte que sur au moins 50 %, en particulier au moins 80 % de la surface optique active, l'écart maximal par rapport au profil d'épaisseur de couche théorique prédéfini est réduit d'au moins 50 %, en particulier d'au moins 80 %, en comparaison avec un miroir de structure analogique dans lequel le premier et le deuxième système de couches présentent un profil d'épaisseur de couche identique.

4. Procédé selon l'une quelconque des revendications 1 à 3, **caractérisé en ce que** la subdivision virtuelle de la structure en couches prédéfinie à l'étape a) est effectuée en exactement deux systèmes de couches.

5. Procédé selon la revendication 4, **caractérisé en ce que** les profils d'épaisseur de couche théoriques individuels pour ces systèmes de couches (610, 710, 620, 720) sont mutuellement complémentaires quant à la longueur de trajet optique.

6. Procédé selon l'une quelconque des revendications précédentes, **caractérisé en ce que** les au moins deux systèmes de couches (610, 710, 620, 720, 730) sont symétriques en rotation.

7. Procédé selon l'une quelconque des revendications précédentes, **caractérisé en ce que** les au moins deux systèmes de couches (610, 710, 620, 720, 730) présentent respectivement une variation d'épaisseur dans la direction latérale.

8. Procédé selon l'une quelconque des revendications précédentes, **caractérisé en ce que** pour une longueur d'onde de travail prédéfinie, le profil d'épaisseur de couche théorique correspond à un tracé de réflectivité théorique du miroir, les profils d'épaisseur de couche théoriques individuels étant sélectionnés de telle sorte qu'un écart maximal du tracé de réflectivité réel par rapport à ce tracé de réflectivité théorique pour la longueur d'onde de travail est inférieur à 0,5 %, en particulier inférieur à 0,3 %.

9. Procédé selon l'une quelconque des revendications précédentes, **caractérisé en ce que** le miroir présente un système de couches de réflexion, le premier système de couches (610, 710) étant une couche fonctionnelle n'appartenant pas au système de couches de réflexion, en particulier une couche de protection de substrat, une couche de compensation de tension, une couche d'adhésif ou une couche de polissage, et dans lequel le deuxième système de couches (620, 720) est un système de couches de réflexion.

10. Procédé selon l'une quelconque des revendications 1 à 8, **caractérisé en ce que** le premier système de couches et le deuxième système de couches comprennent respectivement au moins une couche à l'intérieur d'un système de couches de réflexion.

11. Procédé selon l'une quelconque des revendications précédentes, **caractérisé en ce que** l'un des au moins deux profils d'épaisseur de couche théoriques individuels est sélectionné en fonction d'un profil d'épaisseur de couche établi par une mesure sur un miroir d'essai fabriqué préalablement.

12. Miroir, en particulier pour un équipement d'exposition par projection pour microlithographie, comprenant un substrat de miroir
• dans lequel, sur le substrat de miroir (605, 705), un premier système de couches (610, 710) doté d'un premier profil d'épaisseur de couche et au moins un deuxième système de couches (620, 720) doté d'un deuxième profil d'épaisseur de couche sont disposés, un effet de front d'onde du deuxième système de couches (620, 720) étant au moins partiellement compensé par l'effet de front d'onde du premier système de couches (610, 710), **caractérisé en ce que**
• les profils d'épaisseur de couche théoriques individuels sont réalisés de telle sorte que pour une longueur d'onde de travail prédéfinie, un écart maximal du tracé de réflectivité du miroir par rapport à un tracé de réflectivité théorique donné est inférieur à 0,5 %.

13. Miroir selon la revendication 12, **caractérisé en ce que** le premier et le deuxième profil d'épaisseur de couche sont mutuellement complémentaires quant à la longueur de trajet optique.

14. Miroir selon la revendication 12 ou 13, **caractérisé en ce que** le premier profil d'épaisseur de couche et/ou le deuxième profil d'épaisseur de couche sont symétriques en rotation.

15. Equipement d'exposition par projection pour microlithographie, comprenant un dispositif d'éclairage et un objectif de projection, dans lequel le dispositif d'éclairage éclaire en cours de fonctionnement de l'équipement d'exposition par projection un masque se trouvant dans un plan objet de l'objectif de projection, et l'objectif de projection représente des structures sur ce masque sur une couche photosensible se trouvant dans un plan image de l'objectif de projection, l'équipement d'exposition par projection présentant au moins un miroir selon l'une quelconque des revendications 12 à 14.
